# EUROPÄISCHE PATENTSCHRIFT

(11) **EP 2 184 765 B1**
(45) Veröffentlichungstag und Bekanntmachung des Hinweises auf die Patenterteilung: **14.12.2011**
(21) Anmeldenummer: 09173469.9
(22) Anmeldetag: 20.10.2009
(51) Int. Cl.: H01L 21/00

(54) **Chip-Auswerfer**
Die-ejector
Ejecteur de puce

(30) Priorität: 05.11.2008 CH 17482008; 18.09.2009 CH 14522009
(43) Veröffentlichungstag der Anmeldung: 12.05.2010
(73) Patentinhaber: Esec AG, 6330 Cham (CH)
(72) Erfinder: Schnetzler, Daniel, 6314 Unteraegeri (CH); Muehlemann, Ives, 6330 Cham (CH); Kloeckner, Daniel, 6004 Luzern (CH)
(74) Vertreter: Falk, Urs

(56) Entgegenhaltungen:
- US-A1- 2005 059 205
- US-B1- 6 386 815

## Beschreibung

Die Erfindung betrifft einen Chip-Auswerfer, der bei der Montage von Halbleiterchips eingesetzt wird, um das Ablösen und Entnehmen eines Halbleiterchips von einer Folie zu unterstützen.

Die Halbleiterchips werden typischerweise auf einer von einem Rahmen gehaltenen Folie, in der Fachwelt auch als Tape bekannt, zur Abarbeitung auf einer Halbleiter-Montageeinrichtung bereitgestellt. Die Halbleiterchips haften auf der Folie. Der Rahmen mit der Folie wird von einem verschiebbaren Wafertisch aufgenommen. Taktweise werden der Wafertisch verschoben, um einen Halbleiterchip nach dem anderen an einem Ort bereitzustellen, und dann der bereitgestellte Halbleiterchip von einem Chipgreifer aufgenommen und auf einem Substrat plaziert. Die Entnahme des bereitgestellten Halbleiterchips von der Folie wird von einem unterhalb der Folie angeordneten Chip-Auswerfer (in der Fachwelt bekannt als Die-Ejector) unterstützt.

In vielen Fällen unterstützt eine oder mehrere im Chip-Auswerfer angeordnete Nadel das Ablösen des Halbleiterchips von der Folie. Nadelunterstützte Verfahren sind aus einer Vielzahl von Patenten bekannt, beispielsweise aus US 20040105750 oder US 7265035. Bei der US 2008086874 enthält der Chip-Auswerfer einen Block mit einer Vielzahl von Stäben, die ein flaches Ende aufweisen, und einen zweiten Block mit einer Vielzahl von Nadeln, wobei die Nadeln zwischen den Stäben angeordnet sind und wobei die Fläche des flachen Endes jedes Stabes ein mehrfaches des Querschnitts einer Nadel beträgt. Zum Ablösen des Halbleiterchips wird zuerst der Block mit den Stäben angehoben und dann wird der Block mit den Nadeln angehoben, bis die Nadeln über die Stäbe hervorstehen.

Aus der WO 2005117072 ist ein Chip-Auswerfer mit stützenden Strukturen bekannt, auf denen die Folie während des ganzen Ablöseprozesses aufliegt. Die stützenden Strukturen sind umgeben von Stäben mit einem flachen Ende, die in Richtung zum Halbleiterchip wie auch in entgegengesetzter Richtung verschiebbar sind. Die stützenden Strukturen und die Stäbe können auch durch eine Vielzahl von matrixartig angeordneten einzelnen Stösseln gebildet sein.

Aus der US 20050059205 ist ein Chip-Auswerfer bekannt, der mehrere nebeneinander liegende Platten aufweist, die zum Ablösen des Halbleiterchips entweder gemeinsam angehoben und dann von aussen nach innen sequenziell abgesenkt werden oder von aussen nach innen sequenziell angehoben werden, um eine pyramidenförmige, über die Stützebene hinausragende Erhöhung zu bilden.

Bekannt sind auch verschiedene Verfahren, bei denen der Halbleiterchip ohne Mithilfe einer Nadel von der Folie abgelöst wird: Bei der US 4921564 wird die Folie unterhalb des Halbleiterchips an vielen einzelnen Stellen mit Vakuum beaufschlagt, um die Folie an diesen Stellen vom Halbleiterchip abzuziehen. Bei der US 2002129899 und der US 7238593 wird die Folie über eine Kante des Chip-Auswerfers gezogen und dabei abgelöst. Bei der US 6561743 wird die Folie zunächst in einem Randbereich des Halbleiterchips mittels Vakuum abgezogen und dann relativ zum vom Chipgreifer festgehaltenen Halbleiterchip verschoben, wobei der Halbleiterchip von der Folie abgelöst wird.

Die Dicke der abzulösenden Halbleiterchips nimmt laufend ab. Heutzutage beträgt die Dicke in vielen Fällen bereits weniger als 100 Mikrometer, mit der Tendenz zu weiter reduzierten Dicken von 20 bis 10 oder nur 5 Mikrometern. Dazu kommt, dass die Wafer auf ihrer Rückseite manchmal mit einer Klebschicht versehen sind. Die Haftung der Halbleiterchips auf der Folie vergrössert sich deswegen. Die oben beschriebenen Technologien genügen nicht mehr und/oder sind nicht zuverlässig genug oder sind relativ langsam, d.h. es kommt zu oft vor, dass ein Halbleiterchip beim Ablösen beschädigt oder zerstört wird.

Der Erfindung liegt die Aufgabe zugrunde, einen Chip-Auswerfer zu entwickeln, der ein schnelles, zuverlässiges und beschädigungsfreies Ablösen der Halbleiterchips, insbesondere von dünnen Halbleiterchips, von der Folie ermöglicht.

Die genannte Aufgabe wird erfindungsgemäss gelöst durch die Merkmale des Anspruchs 1. Vorteilhafte Ausführungen sind in den Unteransprüchen angegeben.

Ein erfindungsgemässer Chip-Auswerfer umfasst eine mit Vakuum beaufschlagbare Kammer mit einer Abdeckplatte, die ein Loch aufweist, und eine Vielzahl von Platten, die im Innern der Kammer angeordnet sind, in das erste Loch hineinragen und in einer senkrecht oder schräg zur Oberfläche der Abdeckplatte verlaufenden Richtung verschiebbar sind. Der Chip-Auswerfer umfasst weiter Antriebsmittel, um die Platten zu verschieben. Die Antriebsmittel umfassen zumindest einen Antriebsmechanismus, der einen Motor und einen entlang einer vorbestimmten Bahn bewegbaren Stift aufweist, der vom Motor zwischen zwei Positionen hin und her bewegbar ist. Jede der Platten enthält eine bahnförmige Öffnung. Der Stift ist durch die bahnförmige Öffnung von jeder der Platten hindurchgeführt, wobei die bahnförmige Öffnung von Platte zu Platte derart unterschiedlich ist, dass die Platten in einer vorbestimmten Reihenfolge in der genannten Richtung verschoben werden, wenn der Stift entlang der Bahn bewegt wird.

Die Antriebsmittel umfassen mit Vorteil einen weiteren Antriebsmechanismus, mit dem die Platten gemeinsam in der genannten Richtung verschiebbar sind.

Die Platten sind bevorzugt zweiteilig ausgeführt, nämlich mit einem ersten Teil, das die bahnförmige Öffnung enthält, und einem zweiten Teil, das auf das erste Teil aufsteckbar ist. Die ersten Teile aller Platten sind in der genannten Kammer angeordnet und an den Antriebsmechanismus gekoppelt. Dies ermöglicht eine einfache Anpassung des Chip-Auswerfers an Halbleiterchips unterschiedlicher Grösse. Die ersten Teile aller Platten könnten somit auch als Bestandteil des Antriebsmechanismus angeschen werden, während die für eine spezifische Anwendung aufgesteckten zweiten Teile der Platten, deren Anzahl geringer als die Anzahl der ersten Teile sein kann, als die eigentlichen Platten angesehen werden könnten.

Die Erfindung wird nachfolgend anhand eines Ausführungsbeispiels und anhand der Zeichnung näher erläutert. Die Figuren sind nicht massstäblich gezeichnet.
- Fig. 1: zeigt in seitlicher Ansicht und im Querschnitt einen Chip-Auswerfer,
- Fig. 2: zeigt den Chip-Auswerfer in Aufsicht,
- Fig. 3 bis 6: zeigen Momentaufnahmen während der Ablösung und Entnahme eines Halbleiterchips von einer Folie,
- Fig. 7: zeigt Teile des Chip-Auswerfers, und
- Fig. 8: zeigt eine aus zwei Teilen bestehende Platte.

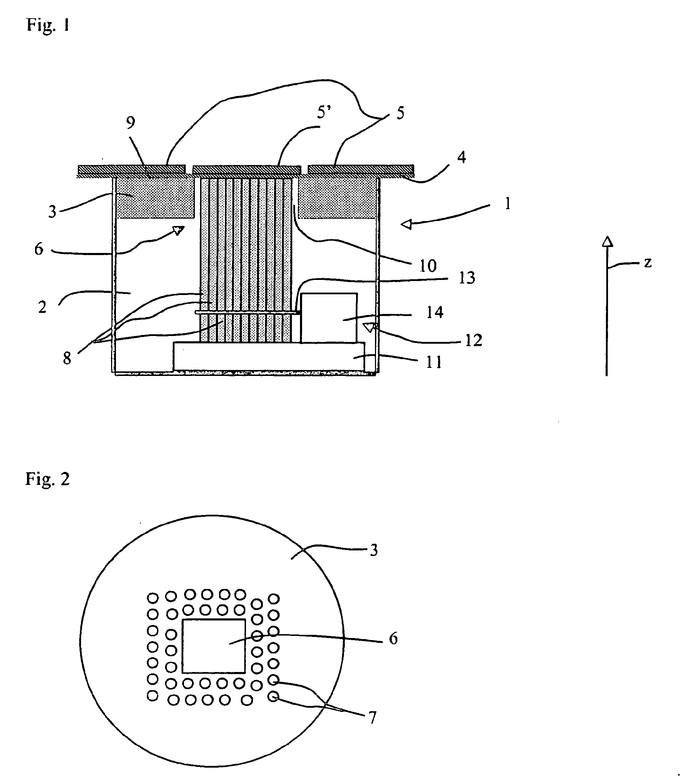

Die Fig. 1 zeigt in seitlicher Ansicht und im Querschnitt einen erfindungsgemässen Chip-Auswerfer 1. Der Chip-Auswerfer 1 umfasst eine geschlossene, mit Vakuum beaufschlagbare Kammer 2 mit einer vorzugsweise abnehmbaren und auswechselbaren Abdeckplatte 3, auf der ein Teil der Folie 4 mit den Halbleiterchips 5 aufliegt. Die Kammer 2 kann auch durch das Gehäuse des Chip-Auswerfers 1 gebildet oder ein Teil davon sein. Die Abdeckplatte 3 kann auch ein Deckel sein. Die Abdeckplatte 3 enthält in der Mitte ein rechteckförmiges Loch 6, das etwa gleich gross wie die Halbleiterchips 5 ist, und bevorzugt eine Vielzahl von weiteren Löchern 7, die nur in der Fig. 2 dargestellt sind und dazu dienen, die Folie 4 anzusaugen, wenn die Kammer 2 mit Vakuum beaufschlagt wird. Der Chip-Auswerfer 1 umfasst weiter eine Vielzahl von Platten 8, die im Innern der Kammer 2 nebeneinander angeordnet sind und in einer als z-Richtung bezeichneten Richtung gemeinsam und/oder einzeln verschiebbar sind. Die z-Richtung verläuft wie im Beispiel bevorzugt senkrecht zur Oberfläche 9 der Abdeckplatte 3 oder zumindest unter einem Winkel schräg zur Oberfläche 9 der Abdeckplatte 3, wobei der Winkel den Winkel bezeichnet, den die z-Richtung mit der Senkrechten zur Oberfläche 9 der Abdeckplatte 3 einschliesst. Der Winkel kann in einem grossen Bereich von 0 bis 80° liegen und ist in der Regel nur durch die Platzverhältnisse beschränkt. Der Winkel ist aber deutlich verschieden von 90°, da der Rahmen der Erfindung verlassen wird, wenn die Platten 8 parallel zur Oberfläche 9 der Abdeckplatte 3 verschoben werden. Die Platten 8 ragen in das zentrale Loch 6 der Abdeckplatte 3 hinein und liegen mit Vorteil aneinander an. Zwischen den Platten 8 und dem Rand des Lochs 6 besteht ein umlaufender Spalt 10. Die Kammer 2 ist mit Vakuum beaufschlagbar. Die von den Platten 8 innerhalb des Lochs 6 der Abdeckplatte 3 des Chip-Auswerfers 1 (Fig. 1) eingenommene Fläche ist bevorzugt etwas kleiner als die Fläche eines Halbleiterchips 5, nämlich so bemessen, dass der Halbleiterchip 5 die von den Platten 8 eingenommene Fläche auf allen Seiten in seitlicher Richtung um etwa 0.5 bis 1 Millimeter überragt. Die Anzahl der Platten 8 hängt von den Abmessungen des Halbleiterchips 5 ab, sie beträgt mindestens drei, nämlich bei sehr kleinen Halbleiterchips von 3*3 Millimetern.

Unter dem Begriff Platten sind alle Objekte zu verstehen, die die gleiche Funktion ausüben können. So können die Platten 8 beispielsweise auch Stäbe oder Balken sein. Weiters können die Platten, Stäbe, Balken, etc. aneinander anliegen oder wenn es die Platzverhältnisse zulassen auch durch Abstände getrennt angeordnet sein.

Der Chip-Auswerfer 1 umfasst weiter Antriebsmittel, um die Platten 8 gemeinsam wie auch einzeln in z-Richtung zu verschieben. Diese Antriebsmittel umfassen, wie im Beispiel dargestellt, bevorzugt einen ersten Antriebsmechanismus 11 und einen zweiten Antriebsmechanismus 12. Der erste Antriebsmechanismus 11 dient dazu, alle Platten 8 gemeinsam und bei diesem Beispiel auch den zweiten Antriebsmechanismus 12 in z-Richtung zu verschieben. Der zweite Antriebsmechanismus 12 dient dazu, die Platten 8 einzeln in einer vorbestimmten Reihenfolge in z-Richtung zu verschieben. Der zweite Antriebsmechanismus 12 ist basierend auf dem Prinzip der Kurvenscheibe so ausgebildet, dass die Platten 8 zwangsgeführt in z-Richtung verschoben werden. Diese Lösung hat den Vorteil, dass keine Federn benötigt werden.

Die Fig. 2 zeigt die Abdeckplatte 3 der Kammer 2 des Chip-Auswerfers 1 in Aufsicht.

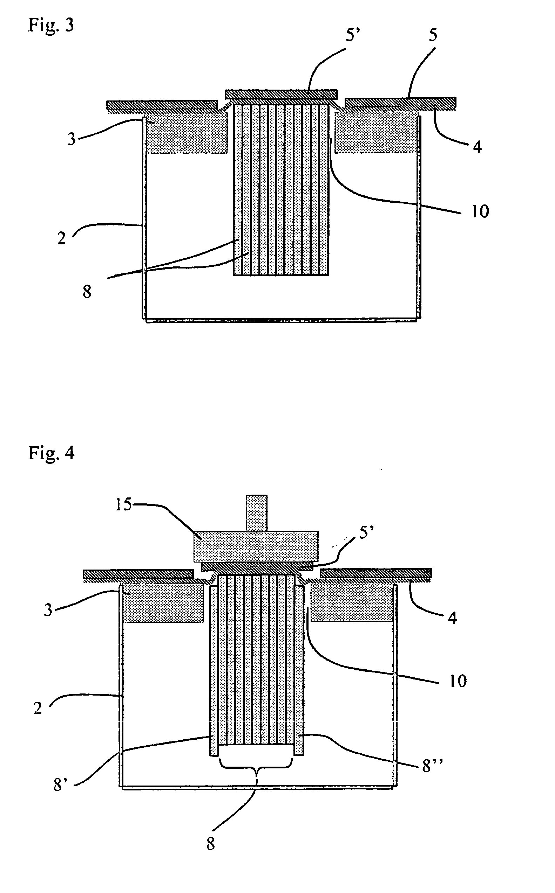

Das Ablösen und Entnehmen eines Halbleiterchips 5 von der Folie 4 erfolgt mittels des Chip-Auswerfers 1 in Zusammenarbeit mit einem Chipgreifer 15 (Fig. 4). Der Chipgreifer 15 enthält mit Vorteil ein mit Vakuum beaufschlagbares Saugorgan, das den Halbleiterchip ansaugt und festhält. Der Chipgreifer 15 kann aber auch ein auf dem Bernoulli-Effekt basierendes Saugorgan enthalten, das mit Druckluft versorgt werden muss, um die Saugwirkung zu erzielen. Das Verfahren zum Ablösen eines Halbleiterchips wird nun anhand der Fig. 1 und der Fig. 3 bis 6 im Detail erläutert, wobei diese Figuren jeweils eine Momentaufnahme darstellen. Die Antriebsmittel für die Bewegung der Platten 8 sind in den Fig. 3 bis 6 nicht dargestellt. Eine Bewegung der Platten 8 in positiver z-Richtung wird als Anheben und eine Bewegung der Platten 8 in negativer z-Richtung als Absenken bezeichnet. Die der Folie 4 zugewandten Seiten der Platten 8 sind zu Beginn in etwa bündig mit der Oberfläche 9 der Abdeckplatte 3. Einige der Platten 8 sind speziell als Platten 8', 8"und 8"' bezeichnet. Das Verfahren umfasst die folgenden Schritte A bis D:
A) die Folie 4 relativ zum Chip-Auswerfer 1 so verschieben, dass sich der abzulösende Halbleiterchip 5' oberhalb des Lochs 6 der Abdeckplatte 3 befindet,
B) Beaufschlagen der Kammer 2 mit Vakuum, wodurch die Folie 4 an die Abdeckplatte 3 gezogen wird,
C) Absenken von einzelnen oder allen der Platten 8 nacheinander in einer vorbestimmten Reihenfolge, und
D) Wegfahren des Chipgreifers 15 mit dem Halbleiterchip 5',
   wobei nach dem Schritt A oder nach dem Schritt B oder nach dem Schritt C der Chipgreifer 15 abgesenkt wird und den Halbleiterchip 5' ansaugt und festhält.

In vielen Fällen ist es von Vorteil, zwischen dem Schritt B und dem Schritt C den folgenden Schritt durchzuführen:
BC) gemeinsames Anheben der Platten 8 um eine erste vorbestimmte Distanz, die so gewählt ist, dass
   die der Folie 4 zugewandten Seiten der Platten 8 über die Oberfläche 9 der Abdeckplatte 3 hinausragen.

Das Absenken der Platten 8 im Schritt C beginnt bevorzugt entweder mit einer der beiden äussersten Platten 8', 8", nämlich der äussersten linken Platte 8' oder der äussersten rechten Platte 8", oder gleichzeitig mit beiden äussersten Platten 8' und 8". Das Absenken der Platten 8 kann aber auch mit einer beliebigen anderen Platte beginnen. Die Platten 8 werden um eine zweite vorbestimmte Distanz abgesenkt. Falls der Schritt BC durchgeführt wird, dann ist die zweite vorbestimmte Distanz grösser als die erste vorbestimmte Distanz.

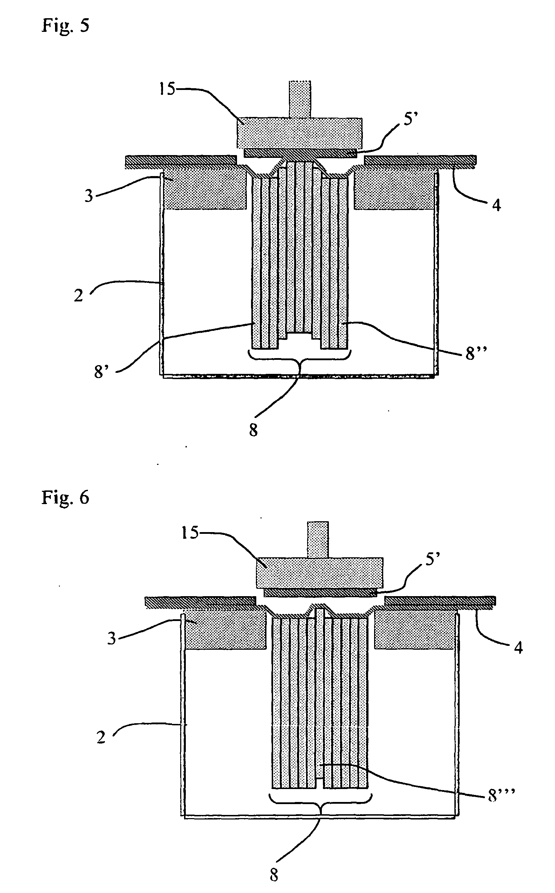

Die Fig. 1 zeigt eine Momentaufnahme nach dem Schritt A. Die Fig. 3 zeigt eine Momentaufnahme nach dem Schritt BC. Die Fig. 4 zeigt eine Momentaufnahme zum Zeitpunkt, bei dem die beiden äussersten Platten 8' und 8" vollständig abgesenkt und die an die äussersten Platten 8' und 8" angrenzenden Platten teilweise abgesenkt sind. Die Folie 4 hat sich vom Rand des Halbleiterchips 5 abgelöst. Die Fig. 5 zeigt eine Momentaufnahme zum Zeitpunkt, bei dem bereits mehrere der Platten 8 vollständig abgesenkt sind. Die Ablösung der Folie 4 vom Halbleiterchip 5 ist weiter fortgeschritten. Die Fig. 6 zeigt eine Momentaufnahme zum Zeitpunkt, bei dem alle Platten 8 mit Ausnahme einer einzigen Platte 8"' in der Mitte vollständig abgesenkt sind. Die Platte 8"' ist bereits teilweise abgesenkt und die Folie 4 vollständig vom Halbleiterchip 5 abgelöst. Das im Spalt 10 herrschende Vakuum übt auf die Unterseite der Folie 4 eine Saugkraft aus und zieht die Folie 4 zur Abdeckplatte 3 des Chip-Auswerfers 1, so dass sich die Folie 4 während des Verfahrensschrittes BC, sofern dieser ausgeführt wird, und während des Verfahrensschrittes C zunehmend vom Halbleiterchip 5 löst und spätestens mit dem Verfahrenschritt D abgeschlossen wird.

Ab welchem Zeitpunkt die Unterstützung des Chipgreifers 15 erforderlich ist für die Ablösung der Folie 4 vom Halbleiterchip 5 hängt von mehreren Faktoren ab wie beispielsweise der Dicke der Halbleiterchips 5, der Grösse der Halbleiterchips, 5, der Haftkraft der Folie 4, der vom Vakuum auf die Folie 4 ausgeübten Saugkraft. Je später der Chipgreifer 15 eingesetzt werden muss, desto grösser ist der Durchsatz des Montageautomaten.

Um die Entnahme des nächsten Halbleiterchips 5 vorzubereiten, werden die Platten 8 wieder in die Anfangsstellung gemäss Fig. 1 gebracht.

Die Antriebsmittel des Chip-Auswerfers 1 sind erfindungsgemäss so gewählt, dass der Verfahrensschritt C bzw. die Verfahrensschritte BC und C in sehr kurzer Zeit von typischerweise weniger als 100 ms durchgeführt werden können. Dies wird möglich, wenn die Platten 8 zwangsgeführt werden. Die bevorzugte Ausbildung der Antriebsmittel mit zwei Antriebsmechanismen ermöglicht es, die Geschwindigkeit der beiden Verfahrensschritte BC und C einzeln optimieren zu können.

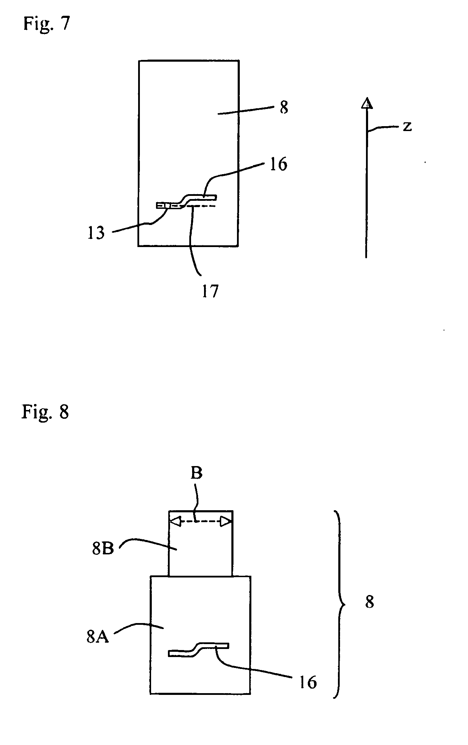

Der erste Antriebsmechanismus 11 (Fig. 1) ist beispielsweise ein pneumatisch bewegbarer Zylinder, der eine erste abgesenkte und eine zweite angehobene Position einnehmen kann. Der erste Antriebsmechanismus 11 kann auch ein elektrischer Antrieb sein, dessen z-Position programmgesteuert einstellbar ist. Der zweite Antriebsmechanismus 12 ist ein auf dem Prinzip der Kurvenscheibe basierender Mechanismus. Der zweite Antriebsmechanismus 12 umfasst einen Motor 14 und einen entlang einer vorbestimmten Bahn 17 bewegbaren Stift 13, der vom Motor 14 zwischen zwei Endpositionen hin und her bewegt wird. Die vorbestimmte Bahn 17 ist bevorzugt eine Gerade oder eine Kreisbahn. Die Platten 8 enthalten jede eine bahnförmige Öffnung 16 (Fig. 7) und der Stift 13 ist durch alle diese Öffnungen hindurchgeführt. Die Fig. 7 zeigt eine der Platten 8 mit der bahnförmigen Öffnung 16 und dem durch sie hindurchgeführten Stift 13 in Aufsicht. Wenn der Stift 13 entlang der Bahn 17, die bei diesem Beispiel eine horizontal verlaufende Gerade ist, vom linken Ende der Bahn 17 zum rechten Ende der Bahn 17 bewegt wird, dann wird die Platte 8 in negativer z-Richtung bewegt, nämlich auf dem kurzen mittleren Abschnitt der Öffnung 16, der gegenüber den seitlichen Abschnitten schräg verläuft. Weil der Stift 13 bei dieser Ausführung immer die gleiche z-Position einnimmt, wird die Platte 8 in z-Richtung abgesenkt, wenn der Stift 13 den mittleren schrägen Abschnitt durchläuft. Dieser mittlere Abschnitt der Öffnung 16 ist von Platte 8 zu Platte 8 an unterschiedlicher Stelle platziert, so dass die Platten 8 wie gewünscht in einer vorbestimmten Reihenfolge in z-Richtung abgesenkt werden. Wenn der Stift 13 nicht auf einer Geraden, sondern auf einer Kreisbahn bewegt wird, dann haben die bahnförmigen Öffnungen 16 einen dementsprechend anderen Verlauf.

Es ist auch möglich, die mit dem ersten Antriebsmechanismus 11 (Fig. 1) zu bewirkende Bewegung in den zweiten Antriebsmechanismus 12 zu integrieren, so dass der erste Antriebsmechanismus 11 entfallen kann. In diesem Fall sind die bahnförmigen Öffnungen 16 der Platten 8 mit einem zusätzlichen Abschnitt zu versehen, der die gleichzeitige Anhebung der Platten 8 in z-Richtung um eine vorbestimmte Distanz bewirkt.

Damit der Chip-Auswerfer 1 an Halbleiterchips unterschiedlicher Grösse angepasst werden kann, sind die Platten 8, wie in der Fig. 8 dargestellt, bevorzugt zweiteilig ausgeführt, nämlich mit einem unteren Teil 8A, das die bahnförmige Öffnung 16 enthält, und einem oberen Teil 8B, das auf das untere Teil 8A aufsteckbar ist. Die unteren Teile 8A der Platten 8 bleiben unverändert im Chip-Auswerfer 1, während die Anzahl und Breite B der oberen Teile 8B der Platten 8 und das Loch 6 in der Abdeckplatte 3 an die Abmessungen des Halbleiterchips angepasst werden.

## Patentansprüche

1. Chip-Auswerfer (1), mit einer mit Vakuum beaufschlagbaren Kammer (2) mit einer Abdeckplatte (3), die ein Loch (6) aufweist, mit einer Vielzahl von Platten (8), die im Innern der Kammer (2) angeordnet sind, in das Loch (6) hineinragen und in einer senkrecht oder schräg zur Oberfläche (9) der Abdeckplatte (3) verlaufenden Richtung verschiebbar sind, und mit Antriebsmitteln, um die Platten (8) zu verschieben, **dadurch gekennzeichnet, dass** die Antriebsmittel einen Antriebsmechanismus (12) umfassen, der einen Motor (14) und einen entlang einer vorbestimmten Bahn (17) bewegbaren Stift (13) aufweist, der vom Motor (14) zwischen zwei Positionen hin und her bewegbar ist, dass jede der Platten (8) eine bahnförmige Öffnung (16) enthält und dass der Stift (13) durch die bahnförmige Öffnung (16) von jeder der Platten (8) hindurchgeführt ist, wobei die bahnförmige Öffnung (16) von Platte (8) zu Platte (8) derart unterschiedlich ist, dass die Platten (8) in einer vorbestimmten Reihenfolge in der genannten Richtung verschoben werden, wenn der Stift (13) entlang der Bahn (17) bewegt wird.

2. Chip-Auswerfer (1) nach Anspruch 1, **dadurch gekennzeichnet, dass** die Antriebsmittel einen weiteren Antriebsmechanismus (11) umfassen, mit dem die Platten (8) gemeinsam in der genannten Richtung verschiebbar sind.

3. Chip-Auswerfer (1) nach Anspruch 1 oder 2, **dadurch gekennzeichnet, dass** die Platten (8) ein erstes Teil (8A), das die bahnförmige Öffnung (16) enthält, in der Kammer (2) angeordnet und an den genannten Antriebsmechanismus (12) gekoppelt ist, und ein zweites Teil (8B), das auf das erste Teil (8A) aufsteckbar ist, umfassen.

## Claims

1. Die ejector (1), with a chamber (2) having a cover plate (3) which chamber can be subjected to a vacuum, the cover plate having a hole (6),
with a plurality of plates (8) arranged in the interior of the chamber (2), protruding into the hole (6) and displaceable in a direction extending perpendicular or in an oblique way in relation to the surface (9) of the cover plate (3), and
with drive means for displacing the plates (8),
**characterized in that**
the drive means comprise a drive mechanism (12) having a motor (14) and a pin (13),
the pin (13) movable back and forth between two positions along a predetermined path (17) by the motor (14),
**in that** each of the plates (8) has a path-like opening (16) and **in that** the pin (13) is guided through the path-like opening (16) of each of the plates (8), with the path-like opening (16) being different from plate (8) to plate (8) in such a way that the plates (8) are displaced in a predetermined sequence in the mentioned direction when the pin (13) is moved along the path (17).

2. Die ejector (1) according to claim 1, **characterized in that** the drive means comprise a further drive mechanism (11) with which the plates (8) are jointly displaceable in the mentioned direction.

3. Die ejector (1) according to claim 1 or 2, **characterized in that** the plates (8) comprise a first part (8A) which contains the path-like opening (16), is arranged in the chamber (2) and coupled to the mentioned drive mechanism (12), and a second part (8B) which can be inserted on the first part (8A).

## Revendications

1. Éjecteur de puces (1), comprenant une chambre qui peut être soumise à un vide (2) avec une plaque de recouvrement (3) qui présente un trou (6) et comprenant une pluralité de plaques (8) qui sont agencées à l'intérieur de la chambre (2), avancent jusque dans le trou (6) et peuvent être déplacées dans une direction qui s'étend perpendiculairement ou en biais par rapport à la surface (9) de la plaque de recouvrement (3) et comprenant des moyens d'entraînement afin de déplacer les plaques (8), **caractérisé en ce que** les moyens d'entraînement comportent un mécanisme d'entraînement (12) qui présente un moteur (14) et une goupille (13) qui peut être déplacée le long d'une trajectoire prédéterminée (17) et qui peut être déplacée en va-et-vient par le moteur (14) entre deux positions, que chacune des plaques (8) contient une ouverture en forme de trajectoire (16) et que la goupille (13) est guidée à travers l'ouverture en forme de trajectoire (16) de chacune des plaques (8), dans lequel l'ouverture en forme de trajectoire (16) est différente d'une plaque (8) à une plaque (8) de telle sorte que les plaques (8) sont déplacées selon une séquence prédéterminée dans la direction mentionnée lorsque la goupille (13) est déplacée le long de la trajectoire (17).

2. Éjecteur de puces (1) selon la revendication 4, **caractérisé en ce que** les moyens d'entraînement comportent un autre mécanisme d'entraînement (11) avec lequel les plaques (8) peuvent être déplacées conjointement dans la direction mentionnée.

3. Éjecteur de puces (1) selon l'une ou l'autre des revendications 4 et 5, **caractérisé en ce que** les plaques (8) comportent une première partie (8A) qui contient l'ouverture en forme de trajectoire (16), est agencée dans la chambre (2) et est accouplée sur le mécanisme d'entraînement mentionné (12), et une seconde partie (8B) qui peut être emboîtée sur la première partie (8A).
